(19) Europäisches Patentamt / European Patent Office / Office européen des brevets

(11) **EP 4 099 378 A1**

(12) **EUROPEAN PATENT APPLICATION**
published in accordance with Art. 153(4) EPC

(43) Date of publication:
**07.12.2022 Bulletin 2022/49**

(21) Application number: **21780695.9**

(22) Date of filing: **30.03.2021**

(51) International Patent Classification (IPC):
*H01L 23/373* (2006.01)    *C04B 38/00* (2006.01)
*C04B 41/83* (2006.01)    *C04B 35/583* (2006.01)
*H05K 7/20* (2006.01)

(52) Cooperative Patent Classification (CPC):
**C04B 35/583; C04B 38/00; C04B 41/83;
H01L 23/373; H05K 7/20**

(86) International application number:
**PCT/JP2021/013576**

(87) International publication number:
**WO 2021/200971 (07.10.2021 Gazette 2021/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.03.2020 JP 2020064396**

(71) Applicant: **Denka Company Limited
Tokyo 103-8338 (JP)**

(72) Inventors:
• **TAKEDA Makoto**
 **Tokyo 103-8338 (JP)**
• **IKARASHI Koki**
 **Tokyo 103-8338 (JP)**

(74) Representative: **Hoffmann Eitle
Patent- und Rechtsanwälte PartmbB
Arabellastraße 30
81925 München (DE)**

(54) **BORON NITRIDE SINTERED BODY, COMPLEX, METHOD FOR MANUFACTURING THESE, AND HEAT DISSIPATION MEMBER**

(57) Provided is a boron nitride sintered body including boron nitride particles and pores, in which a compressive elastic modulus is 1 GPa or more. Provided is a method for manufacturing a boron nitride sintered body, the method including: a nitriding step of firing a boron carbide powder in a nitrogen atmosphere to obtain a fired product containing boron carbonitride; and a sintering step of molding and heating a blend containing the fired product and a sintering aid to obtain the boron nitride sintered body including boron nitride particles and pores, in which the sintering aid contains a boron compound and a calcium compound, and the blend contains 1 to 20 parts by mass of the boron compound and the calcium compound in total with respect to 100 parts by mass of the fired product.

*Fig.1*

EP 4 099 378 A1

## Description

### Technical Field

The present disclosure relates to a boron nitride sintered body, a composite body, and manufacturing methods therefor.

### Background Art

In components such as a power device, a transistor, a thyristor, and a CPU, efficient dissipation of heat generated during use thereof is required. From such a request, conventionally, a thermal conductivity of an insulating layer of a printed-wiring board onto which an electronic component is to be mounted has been improved, or an electronic component or a printed-wiring board has been mounted onto a heat sink via thermal interface materials having electrical insulation properties. A composite body (heat dissipation member) configured by a resin and ceramic such as boron nitride is used for the insulating layer and the thermal interface material described above.

It has been studied to use a composite body obtained by impregnating a porous ceramic molded body with a resin as such a composite body. Boron nitride has lubricity, high thermal conducting properties, insulation properties, and the like, and from this aspect, it has been studied to use ceramic containing boron nitride for a heat dissipation member. Patent Literature 1 has proposed a technique of adjusting an orientation degree and a graphitization index in predetermined ranges to decrease the anisotropy of the thermal conductivity while attaining an excellent thermal conductivity.

### Citation List

### Patent Literature

Patent Literature 1: Japanese Unexamined Patent Publication No. 2014-162697

### Summary of Invention

### Technical Problem

With an increase in integration density of a circuit inside an electronic component in recent years, a heat dissipation member having further enhanced heat dissipation properties than ever before and a composite body to be suitably used therefor have been demanded.

In this regard, the present disclosure provides a boron nitride sintered body and a composite body which have a sufficiently high thermal conductivity. Furthermore, the present disclosure provides a manufacturing method by which such a boron nitride sintered body and a composite body can be manufactured. Furthermore, the present disclosure provides a heat dissipation member having a sufficiently high thermal conductivity by including the above-described composite body.

### Solution to Problem

In an aspect of the present disclosure, there is provided a boron nitride sintered body including boron nitride particles and pores, in which a compressive elastic modulus is 1 GPa or more. Although the boron nitride particles are hardly sinterable, in the boron nitride sintered body having a sufficiently high compressive elastic modulus, primary particles of boron nitride are bonded firmly and intimately over the broad area while the boron nitride sintered body has pores. The thermal conductivity can be sufficiently increased accordingly.

A compressive strength of the boron nitride sintered body may be 3 MPa or more. Thereby, when the boron nitride sintered body is used as a member of various instruments such as a heat dissipation member, reliability can be improved.

A porosity in the boron nitride sintered body may be 30 to 65% by volume. Furthermore, a bulk density may be 900 to 1500 kg/m$^3$. When at least one of the porosity and the bulk density is in this range, a resin composition can be sufficiently impregnated while sufficiently increasing the thermal conductivity. A composite body in which both an excellent thermal conductivity and insulation properties can be achieved at a high level can be formed with such a boron nitride sintered body.

An orientation index of the boron nitride sintered body may be 20 or less. Thereby, the anisotropy of the thermal conductivity can be sufficiently decreased.

The boron nitride sintered body may have a sheet shape and a thickness of less than 2 mm. Thereby, the impregnating of the pores with the resin composition can be smoothly performed.

According to an aspect of the present disclosure, there is provided a composite body including any of the above-described boron nitride sintered bodies and a resin filled in at least some of the pores of the boron nitride sintered body. This composite body includes the above-described boron nitride sintered body and the resin, and from this aspect, has both an excellent thermal conductivity and excellent insulation properties.

According to an aspect of the present disclosure, there is provided a heat dissipation member having the above-described composite body. This heat dissipation member has the above-described composite body, and from this aspect, has a sufficiently high thermal conductivity.

According to an aspect of the present disclosure, there is provided a method for manufacturing a boron nitride sintered body, the method including: a nitriding step of firing a boron carbide powder in a nitrogen atmosphere to obtain a fired product containing boron carbonitride; and a sintering step of molding and heating a blend containing the fired product and a sintering aid to obtain a boron nitride sintered body including boron nitride particles and pores, in which the sintering aid contains a boron compound and a calcium compound, and the blend contains 1 to 20 parts by mass of the boron compound and the calcium compound in total with respect to 100 parts by mass of the fired product.

In the above-described manufacturing method, the fired product containing boron carbonitride is used in the sintering step. Thus, as compared to the case of using scale-shaped boron nitride particles, sinterability can be improved while suppressing the orientation of the particles. Furthermore, the blend contains a predetermined sintering aid along with the fired product containing boron carbonitride. The grain growth of primary particles of boron nitride appropriately proceeds due to such factors. Hence the primary particles of boron nitride are bonded firmly and intimately over the broad area. Thereby, a boron nitride sintered body having a sufficiently high thermal conductivity while having pores can be manufactured. A compressive elastic modulus of the boron nitride sintered body obtained in the sintering step may be 1 GPa or more.

The blend in the above-described manufacturing method may contain 0.5 to 40 atom% of calcium constituting the calcium compound with respect to 100 atom% of boron constituting the boron compound. When the blend contains boron and calcium in such a ratio, homogeneous grain growth of primary particles is promoted, and the thermal conductivity of the boron nitride sintered body can be further increased.

The boron nitride sintered body obtained in the sintering step may have a sheet shape and a thickness of less than 2 mm. When a sheet-shaped boron nitride sintered body is formed in the sintering step in this way, as compared to a case where a block-shaped boron nitride sintered body is cut into a sheet shape, material loss can be reduced, and thus a sheet-shaped boron nitride sintered body can be manufactured at a high yield. Furthermore, when the thickness is set to be thin, that is, less than 2 mm, the impregnating of the resin composition can be smoothly performed.

According to an aspect of the present disclosure, there is provided a method for manufacturing a composite body, the method including an impregnating step of impregnating the boron nitride sintered body obtained by any of the above-described manufacturing methods with a resin composition, the composite body including the boron nitride sintered body and a resin filled in at least some of the pores of the boron nitride sintered body. The composite body obtained by such a manufacturing method is obtained using the above-described boron nitride sintered body, and from this aspect, has a sufficiently high thermal conductivity.

**Advantageous Effects of Invention**

According to the present disclosure, it is possible to provide a boron nitride sintered body and a composite body which have a sufficiently high thermal conductivity. Furthermore, the present disclosure can provide a manufacturing method by which such a boron nitride sintered body and a composite body can be manufactured. Furthermore, the present disclosure can provide a heat dissipation member having a sufficiently high thermal conductivity by including the above-described composite body.

**Brief Description of Drawings**

FIG. 1 is a perspective view illustrating an example of a boron nitride sintered body.
FIG. 2 is an SEM photograph showing a cross-section of a boron nitride sintered body of Example 1.
FIG. 3 is an SEM photograph showing a cross-section of a boron nitride sintered body of Example 2.
FIG. 4 is an SEM photograph showing a cross-section of a boron nitride sintered body of Comparative Example 1.
FIG. 5 is an SEM photograph showing a cross-section of a boron nitride sintered body of Comparative Example 2.

**Description of Embodiments**

Hereinafter, embodiments of the present disclosure will be described with reference to the drawings as necessary. However, the following embodiments are examples for describing the present disclosure and are not intended to limit the present disclosure to the following contents.

A boron nitride sintered body according to an embodiment includes boron nitride particles and pores configured by primary particles of boron nitride being sintered. The compressive elastic modulus of the boron nitride sintered body is 1 GPa or more or may be 1.5 GPa or more. In the boron nitride sintered body having a large compressive elastic modulus, the primary particles of boron nitride are bonded firmly and intimately over the broad area. The thermal conductivity can be sufficiently increased accordingly. The compressive elastic modulus may be 4 GPa or less or may be 3 GPa or less. Thereby, when the boron nitride sintered body or a composite body obtained using the boron nitride sintered body is sandwiched between a pair of members facing each other and then is pressed and bonded, the boron nitride sintered body or the composite body can be appropriately deformed to increase adhesion with the members.

The compressive strength of the boron nitride sintered body may be, for example, 3 MPa or more, may be 5 MPa or more, or may be 10 MPa or more. When the boron nitride sintered body has a high compressive strength, breakage when the boron nitride sintered body is used as a member can be suppressed. The compressive elastic modulus and the compressive strength can be measured using a compression tester (for example, Autograph AG-X (300 kN) manufactured by SHIMADZU CORPORATION) according to JIS K7181. Measurement conditions are as follows.

Compression rate: 1 mm/min
Load cell: 100 kN
Test temperature: 200°C
Sample size: length × width × height = 10 mm × 10 mm × 4 mm

The average pore diameter of the pores included in the boron nitride sintered body may be less than 2 $\mu$m. The contact area between primary particles of the boron nitride particles can be sufficiently increased by decreasing the size of the pores. The thermal conductivity can be further increased accordingly. From the viewpoint of further increasing the thermal conductivity, the average value of diameters of the pores may be less than 1 $\mu$m, may be less than 0.8 $\mu$m, or may be less than 0.6 $\mu$m. From the viewpoint of smoothly performing the impregnating of the boron nitride sintered body with the resin composition, the average value of diameters of the pores may be 0.1 $\mu$m or more or may be 0.2 $\mu$m or more.

The average pore diameter of the pores is determined using a mercury porosimeter on the basis of pore size distribution obtained when pressurization is performed while increasing a pressure from 0.0042 MPa to 206.8 MPa. When the horizontal axis is designated as the pore diameter and the vertical axis is designated as the cumulative pore volume, a pore diameter at which the cumulative pore volume reaches 50% of the total pore volume is an average pore diameter. As the mercury porosimeter, a mercury porosimeter manufactured by SHIMADZU CORPORATION can be used.

The peak pore diameter of the pores may be less than 2 $\mu$m, may be less than 1 $\mu$m, may be less than 0.8 $\mu$m, or may be less than 0.6 $\mu$m. The "peak pore diameter" in the present disclosure is a pore diameter when a value obtained by dividing a differential pore volume (dV) by a logarithmic differential value d (logD) of a pore diameter is a maximum value, in a graph showing a Log differential pore volume distribution.

The porosity of the boron nitride sintered body, that is, the volumetric ratio of the pores in the boron nitride sintered body may be 30 to 60% by volume or may be 35 to 55% by volume. When the porosity is too large, the strength of the boron nitride sintered body tends to decrease. When the porosity is too small, there is a tendency that the content of the resin when a composite body is manufactured is decreased to degrade insulation properties.

A bulk density [B (kg/m$^3$)] is calculated from the volume and mass of the boron nitride sintered body, and then the porosity can be determined by Formula (1) below from this bulk density and the theoretical density [2280 (kg/m$^3$)] of boron nitride.

$$\text{Porosity (\% by volume)} = [1 - (B/2280)] \times 100 \qquad (1)$$

The bulk density B may be 900 to 1500 kg/m$^3$ or may be 1000 to 1400 kg/m$^3$. When the bulk density B is too small, the strength of the boron nitride sintered body tends to decrease. When the bulk density B is too large, there is a tendency that the impregnation rate of the resin is decreased to degrade the insulation properties of the composite body.

The thermal conductivity of the boron nitride sintered body may be 40 W/(m·K) or more, may be 45 W/(m·K) or more, or may be 57 W/(m·K) or more. When the boron nitride sintered body having a high thermal conductivity is used, a heat dissipation member sufficiently excellent in heat dissipation performance can be obtained. The thermal conductivity (H) can be determined by Calculation Formula (2) below.

$$H = A \times B \times C \qquad (2)$$

In Formula (2), H represents a thermal conductivity (W/(m·K)), A represents a thermal diffusivity (m²/sec), B represents a bulk density (kg/m³), and C represents a specific heat capacity (J/(kg·K)). The thermal diffusivity A can be measured by a laser flash method. The bulk density B can be measured from the volume and mass of the boron nitride sintered body. The specific heat capacity C can be measured using a differential scanning calorimeter.

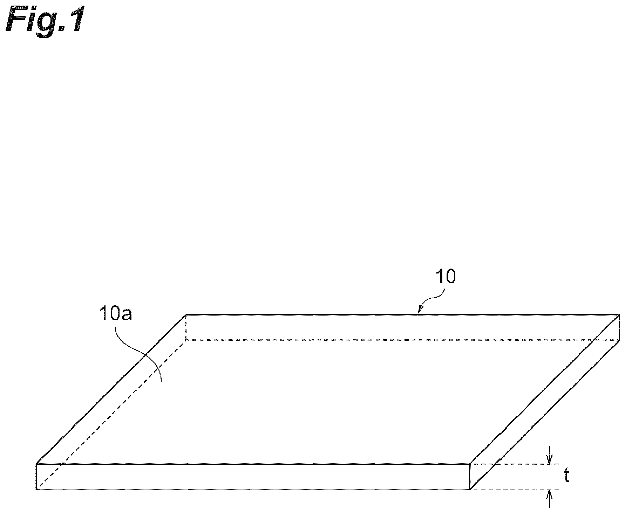

The boron nitride sintered body may have a sheet shape (thin plate shape) as shown in FIG. 1. Since the thickness of a boron nitride sintered body 10 is small, the impregnating of the resin composition can be smoothly performed. Thereby, the resin can be sufficiently filled in the pores of the boron nitride sintered body, and the composite body excellent in insulation properties can be obtained. A thickness t of the boron nitride sintered body 10 may be less than 2 mm, may be less than 1 mm, or may be less than 0.5 mm. From the viewpoint of ease of producing a molded body, the thickness t of the boron nitride sintered body 10 may be 0.1 mm or more, or may be 0.2 mm or more. The area of a main surface 10a of the boron nitride sintered body 10 may be 500 mm² or more, may be 800 mm² or more, or may be 1000 mm² or more.

The shape of the boron nitride sintered body is not limited to the shape of FIG. 1, and for example, may be a disk-shaped sheet shape or may be a C-shaped sheet shape in which the main surface 10a is curved. Furthermore, a block-shaped boron nitride sintered body may be cut and/or polished to be processed into a sheet shape as shown in FIG. 1. However, when processing such as cutting is performed, material loss occurs. Hence, when a sheet-shaped boron nitride sintered body is produced using a sheet-shaped molded body, material loss can be reduced. Thereby, the yield of the boron nitride sintered body and the composite body can be improved. Note that, when the block-shaped boron nitride sintered body is, for example, a polyhedron, all of sides have a proportionate length, and the block-shaped boron nitride sintered body has a larger thickness than the sheet-shaped boron nitride sintered body. That is, the block shape refers to a shape which can be divided into a plurality of sheet shapes (thin plate shapes) by cutting.

The orientation index of boron nitride crystals in the boron nitride sintered body may be 20 or less, may be 15 or less, or may be 10 or less. Thereby, the anisotropy of the thermal conducting properties can be sufficiently decreased. In the case of the sheet shape as shown in the boron nitride sintered body 10, the thermal conductivity along the thickness direction can be sufficiently increased accordingly. The thermal conductivity along the thickness direction may be 40 W/(m·K) or more, may be 45 W/(m·K) or more, or may be 57 W/(m·K) or more. The orientation index of the boron nitride sintered body may be 2.0 or more, may be 3.0 or more, or may be 4.0 or more. The orientation index in the present disclosure is an index for quantifying the orientation degree of boron nitride crystals. The orientation index can be calculated by a peak intensity ratio [I(002)/I(100)] of (002) plane to (100) plane of boron nitride as measured by an X-ray diffractometer.

A composite body according to an embodiment is a composite body of a silicon nitride sintered body and a resin, and the composite body has the above-described boron nitride sintered body and a resin filled in at least some of the pores of the boron nitride sintered body. As the resin, for example, an epoxy resin, a silicone resin, a cyanate resin, a silicone rubber, an acrylic resin, a phenolic resin, a melamine resin, a urea resin, unsaturated polyester, a fluorine resin, polyimide, polyamide imide, polyether imide, polybutylene terephthalate, polyethylene terephthalate, polyphenylene ether, polyphenylene sulfide, wholly aromatic polyester, polysulfone, a liquid crystal polymer, polyether sulfone, polycarbonate, a maleimide resin, a maleimide-modified resin, an ABS (acrylonitrile-butadiene-styrene) resin, an AAS (acrylonitrile-acrylic rubber-styrene) resin, an AES (acrylonitrile-ethylene-propylene-diene rubber-styrene) resin, a polyglycolic acid resin, polyphthalamide, polyacetal, and the like can be used. These may be included singly or in combination of two or more kinds thereof.

In the case of using the composite body for an insulating layer of a printed-wiring board, from the viewpoint of improving heat resistance and adhesion strength to a circuit, the resin may include an epoxy resin. In the case of using the composite body for a thermal interface material, from the viewpoint of improving heat resistance, flexibility, and adhesion to a heat sink or the like, the resin may include a silicone resin. The resin may be a cured product (in a C-stage state), or may be a semi-cured product (in a B-stage state). Whether or not the resin is in a semi-cured state can be checked, for example, by a differential scanning calorimeter.

The content of the boron nitride particles in the composite body may be 40 to 70% by volume or may be 45 to 65% by volume, on the basis of the total volume of the composite body. The content of the resin in the composite body may be 30 to 60% by volume or may be 35 to 55% by volume, on the basis of the total volume of the composite body. In the composite body including the boron nitride particles and the resin in such ratios, both of high insulation properties and a high thermal conductivity can be achieved at a high level.

The content of the resin in the composite body may be 10 to 60% by mass, may be 20 to 55% by mass, or may be 25 to 45% by mass, on the basis of the total mass of the composite body. In the composite body including the resin in such a ratio, both of high insulation properties and a high thermal conductivity can be achieved at a high level. The content of the resin in the composite body can be determined by heating the composite body to decompose and remove the resin and calculating the mass of the resin from a difference in mass before and after heating.

The composite body may further include other components in addition to the boron nitride sintered body and the resin filled in the pores thereof. Examples of the other components include a curing agent, an inorganic filler, a silane coupling agent, a defoamer, a surface conditioner, a wetting and dispersing agent, and the like. The inorganic filler may include one or two or more kinds selected from the group consisting of aluminum oxide, silicon oxide, zinc oxide, silicon nitride, aluminum nitride, and aluminum hydroxide. Thereby, the thermal conducting properties of the composite body can be further improved.

The composite body of the present embodiment includes the above-described boron nitride sintered body and the resin, and from this aspect, has both an excellent thermal conductivity and excellent insulation properties. Therefore, the composite body can be suitably used, for example, as a heat dissipation member. The heat dissipation member may be configured by the above-described composite body, or may be configured by combining another member (for example, a metal plate such as aluminum) and the composite body.

Examples of methods for manufacturing a boron nitride sintered body, a composite body, and a heat dissipation member will be described hereinafter. Note that, description contents of the boron nitride sintered body, the composite body, and the heat dissipation member described above will be applied to the following manufacturing method. The method for manufacturing a boron nitride sintered body of this example includes a nitriding step of firing a boron carbide powder in a nitrogen pressurized atmosphere to obtain a fired product containing boron carbonitride, and a sintering step of molding and heating a blend containing the fired product and a sintering aid to obtain a boron nitride sintered body including boron nitride particles and pores.

The boron carbide powder can be prepared, for example, by the following procedures. Boric acid and acetylene black are mixed and then heated in an inert gas atmosphere at 1800 to 2400°C for 1 to 10 hours to obtain a boron carbide lump. The boron carbide powder can be prepared by subjecting this boron carbide lump to pulverization, washing, impurity removal, and drying.

In the nitriding step, a boron carbide powder is fired in a nitrogen atmosphere to obtain a fired product containing boron carbonitride ($B_4CN_4$). The firing temperature in the nitriding step may be 1800°C or higher or may be 1900°C or higher. Furthermore, this firing temperature may be 2400°C or lower or may be 2200°C or lower. This firing temperature may be, for example, 1800 to 2400°C.

The pressure in the nitriding step may be 0.6 MPa or more or may be 0.7 MPa or more. Furthermore, this pressure may be 1.0 MPa or less or may be 0.9 MPa or less. This pressure may be, for example, 0.6 to 1.0 MPa. When the pressure is too low, there is a tendency that the nitriding of boron carbide is difficult to proceed. When this pressure is too high, there is a tendency that manufacturing cost is increased. Note that, the pressure in the present disclosure is an absolute pressure.

The nitrogen gas concentration of the nitrogen atmosphere in the nitriding step may be 95% by volume or more or may be 99.9% by volume or more. The partial pressure of nitrogen may be in the above pressure range. The firing time in the nitriding step is not particularly limited as long as it is in a range in which the nitriding sufficiently proceeds, and for example, may be 6 to 30 hours or may be 8 to 20 hours.

In the sintering step, a blend is obtained by blending the fired product containing boron carbonitride particles obtained in the nitriding step and a sintering aid. The sintering aid contains a boron compound and a calcium compound. The blend contains 1 to 20 parts by mass of the boron compound and the calcium compound in total with respect to 100 parts by mass of the fired product. When the content is set in such a range, the grain growth is appropriately performed while suppressing excessive grain growth of primary particles to promote the sintering, and the primary particles of boron nitride are bonded firmly and intimately over the broad area.

From the viewpoint of sufficiently bonding the primary particles of boron nitride, the blend may contain, for example, 2 to 20 parts by mass, 3 to 15 parts by mass, or 4 to 10 parts by mass of the boron compound and the calcium compound in total, with respect to 100 parts by mass of the fired product. When the total content of the boron compound and the calcium compound becomes excessively large, there are tendencies that the grain growth of the primary particles of boron nitride proceeds too much, and the pores included in the boron nitride sintered body are increased in size to decrease the compressive strength. When the total content of the boron compound and the calcium compound becomes excessively small, there are tendencies that the grain growth of the primary particles of boron nitride is difficult to proceed, and the compressive elastic modulus of the boron nitride sintered body is increased.

The blend may contain 0.5 to 40 atom% or 0.7 to 30 atom% of calcium constituting the calcium compound with respect to 100 atom% of boron constituting the boron compound. When the blend contains boron and calcium in such a ratio, homogeneous grain growth of primary particles is promoted, and the thermal conductivity of the boron nitride sintered body can be further increased. When the content ratio of the boron compound becomes too large, the pore diameter tends to decrease. When the content ratio of the calcium compound becomes too large, the pore diameter tends to increase.

Examples of the boron compound include boric acid, boron oxide, borax, and the like. Examples of the calcium compound include calcium carbonate, calcium oxide, and the like. The sintering aid may contain a component other than boric acid and calcium carbonate. Examples of such a component include carbonates of alkali metals such as lithium carbonate and sodium carbonate. Furthermore, for moldability improvement, a binder may be blended in the blend. Examples of the binder include an acrylic compound and the like.

The pulverization of the fired product may be performed using a general pulverizer or disintegrator when the fired product and the sintering aid are blended. For example, a ball mill, a Henschel mixer, a vibrating mill, a jet mill, or the like can be used. Note that, in the present disclosure, "disintegration" is also included in "pulverization". The fired product may be pulverized and then blended with the sintering aid, or the fired product and the sintering aid may be blended and then subjected to pulverization and mixing at the same time.

The blend may be subjected to powder pressing or die molding to obtain a molded body, or may be formed into a sheet-shaped molded body by a doctor blade method. The molding pressure may be, for example, 70 to 350 MPa. The shape of the molded body is not particularly limited, and may be, for example, a sheet shape having a thickness of less than 2 mm or 1 mm or less. When a boron nitride sintered body is manufactured using a sheet-shaped molded body, the impregnating of the resin smoothly proceeds. Furthermore, as compared to a case where a block-shaped boron nitride sintered body and a block-shaped composite body are cut into a sheet shape, material loss caused by processing can be reduced in the case of using a molded body which has been formed in a sheet shape. Therefore, a sheet-shaped boron nitride sintered body and a sheet-shaped composite body can be manufactured at a high yield.

The molded body obtained in this way is fired, for example, heating in an electric furnace. The heating temperature may be, for example, 1800°C or higher or may be 1900°C or higher. This heating temperature may be, for example, 2200°C or lower or may be 2100°C or lower. When the heating temperature is too low, there is a tendency that the grain growth does not sufficiently proceed. The heating time may be 0.5 hours or longer, may be 1 hour or longer, may be 3 hours or longer, may be 5 hours or longer, or may be 10 hours or longer. This heating time may be 40 hours or shorter, may be 30 hours or shorter, or may be 20 hours or shorter. This heating time may be, for example, 0.5 to 40 hours or may be 1 to 30 hours. When the heating time is too short, there is a tendency that the grain growth does not sufficiently proceed. On the other hand, a too long heating time tends to be disadvantageous in terms of industrial aspect. The heating atmosphere may be, for example, an inert gas atmosphere such as nitrogen, helium, or argon.

Through the above steps, the boron nitride sintered body including boron nitride particles can be obtained. In this boron nitride sintered body, the grain growth of the primary particles of boron nitride using boron carbonitride is appropriate, and the primary particles are bonded firmly and intimately over the broad area. Thus, a boron nitride sintered body having a sufficiently high thermal conductivity can be obtained.

An example of the method for manufacturing a composite body includes an impregnating step of impregnating a boron nitride sintered body with a resin composition. The boron nitride sintered body may be manufactured by the above-described method. The resin composition may contain a resin component, a curing agent, and a solvent, from the viewpoint of improving fluidity and handleability. Furthermore, the resin composition may contain an inorganic filler, a silane coupling agent, a defoamer, a surface conditioner, a wetting and dispersing agent, and the like, in addition to those components.

As the resin component, for example, those which become the resin having been exemplified in the above description of the composite body by a curing or semi-curing reaction can be used. Examples of the solvent include aliphatic alcohols such as ethanol and isopropanol, ether alcohols such as 2-methoxy ethanol, 1-methoxy ethanol, 2-ethoxy ethanol, 1-ethoxy-2-propanol, 2-butoxyethanol, 2-(2-methoxyethoxy)ethanol, 2-(2-ethoxyethoxy)ethanol, and 2-(2-butoxyethoxy)ethanol, glycol ethers such as ethylene glycol monomethyl ether and ethylene glycol monobutyl ether, ketones such as acetone, methyl ethyl ketone, methyl isobutyl ketone, and diisobutyl ketone, and hydrocarbons such as toluene and xylene. These may be included singly or in combination of two or more kinds thereof.

The impregnating is performed by attaching the resin composition to the boron nitride sintered body. For example, the boron nitride sintered body may be immersed in the resin composition. The impregnating may be performed in the state of the boron nitride sintered body being immersed under a pressurized or depressurized condition. In this way, the resin can be filled in the pores of the boron nitride sintered body.

The impregnating step may be performed using the inside of an impregnating apparatus including an airtight container. As an example, the impregnating may be performed inside the impregnating apparatus under a depressurized condition, and then the impregnating may be performed under a pressurized condition by increasing the pressure inside the impregnating apparatus to be higher than the atmospheric pressure. By performing both the depressurized condition and the pressurized condition in this way, the resin can be sufficiently filled in the pores of the boron nitride sintered body. The depressurized condition and the pressurized condition may be repeated multiple times. The impregnating step may be performed while heating. The resin composition impregnated in the pores of the boron nitride sintered body becomes a resin (a cured product or a semi-cured product) after curing or semi-curing proceeds or the solvent volatilizes. In this way, the composite body having the boron nitride sintered body and a resin filled in the pores thereof is obtained. It is not necessary to fill the resin in all of the pores, and the resin may not be filled in some of the pores. The boron nitride sintered body and the composite body may include both of closed pores and open pores.

The method may include a curing step of curing the resin filled in the pores after the impregnating step. In the curing step, for example, the composite body filled with the resin is extracted from the impregnating apparatus, and then the resin is cured or semi-cured by heating and/or light irradiation depending on the type of the resin (or a curing agent to be added as necessary).

In the composite body obtained in this way, the grain growth of the primary particles of boron nitride in the boron nitride sintered body is appropriate, and the primary particles are bonded firmly and intimately over the broad area. The composite body has a sufficiently high thermal conductivity accordingly. Furthermore, since the resin is filled in the pores of the boron nitride sintered body, the composite body is also excellent in insulation properties. The composite body may be used directly as a heat dissipation member, or may be subjected to processing into a predetermined shape and used as a heat dissipation member.

Hereinbefore, several embodiments have been described, but the present disclosure is not intended to be limited to the above-described embodiments at all. For example, in the sintering step, a boron nitride sintered body may be obtained using a hot press in which molding and sintering are simultaneously performed.

**Examples**

The contents of the present disclosure will be more specifically described with reference to Examples and Comparative Examples; however, the present disclosure is not limited to the following Examples.

[Boron nitride sintered body]

(Example 1)

<Production of boron nitride sintered body>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated in an arc furnace in an argon atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder. The carbon amount of the obtained boron carbide powder was 19.9% by mass. The carbon amount was measured with a carbon/sulfur simultaneous analyzer.

The prepared boron carbide powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

Powdery boric acid and calcium carbonate were blended to prepare a sintering aid. Upon the preparation, 2.0 parts by mass of calcium carbonate was blended with respect to 100 parts by mass of boric acid. Regarding the atomic ratio of boron and calcium at this time, the atomic ratio of calcium was 0.7 atom% with respect to 100 atom% of boron. 6 parts by mass of the sintering aid was blended with respect to 100 parts by mass of the fired product and mixed using a Henschel mixer to obtain a powdery blend.

The blend was pressurized using a powder pressing machine at 150 MPa for 30 seconds to obtain a molded body having a sheet shape (length × width × thickness = 49 mm × 25 mm × 5 mm). The molded body was put in a boron nitride container and introduced into a batch-type high-frequency furnace. In the batch-type high-frequency furnace, heating was performed for 10 hours under the conditions of normal pressure, a nitrogen flow rate of 5 L/min, and 2050°C. Thereafter, a boron nitride sintered body was extracted from the boron nitride container. In this way, a sheet-shaped (flat plate-shaped) boron nitride sintered body was obtained. The thickness of the boron nitride sintered body was 5 mm.

<Measurement of compressive elastic modulus and compressive strength>

The boron nitride sintered body was processed to produce a measurement sample having a prism shape (length × width × height = 10 mm × 10 mm × 4 mm). The compressive elastic modulus and the compressive strength at 200°C were measured using a compression tester (Autograph AG-X (300 kN) manufactured by SHIMADZU CORPORATION) according to JIS K7181. Measurement conditions were set as follows. Results were as shown in Table 1.

    Compression rate: 1 mm/min
    Load cell: 100 kN
    Test temperature: 200°C

<Measurement of thermal conductivity>

The thermal conductivity (H) of the boron nitride sintered body in the thickness direction was determined by Calculation Formula (3) below.

$$H = A \times B \times C \qquad (3)$$

In Formula (3), H represents a thermal conductivity (W/(m·K)), A represents a thermal diffusivity ($m^2$/sec), B represents a bulk density (kg/$m^3$), and C represents a specific heat capacity (J/(kg·K)). The thermal diffusivity A was measured using a sample, which was obtained by processing the boron nitride sintered body into a size of length × width × thickness = 10 mm × 10 mm × 0.40 mm, by a laser flash method. As a measurement apparatus, a xenon flash analyzer (manufactured by NETZSCH-Gerätebau GmbH, trade name: LFA447 NanoFlash) was used.

The bulk density B was calculated from the volume and mass of the boron nitride sintered body. The specific heat capacity C was measured using a differential scanning calorimeter (manufactured by Rigaku Corporation, device name: Thermo Plus Evo DSC8230). Results are shown in Table 1.

<Measurement of porosity>

The volume and mass of the obtained boron nitride sintered body were measured, and the bulk density B (kg/$m^3$) was calculated from the volume and mass. The porosity was determined from this bulk density B and the theoretical density (2280 kg/$m^3$) of boron nitride, by Calculation Formula (4) below. Results were as shown in Table 1.

$$\text{Porosity (\% by volume)} = [1 - (B/2280)] \times 100 \qquad (4)$$

<Measurement of orientation index>

The orientation index [I(002)/I(100)] of the boron nitride sintered body was determined using an X-ray diffractometer (manufactured by Rigaku Corporation, trade name: ULTIMA-IV). A measurement sample (boron nitride sintered body) set on a sample holder of the X-ray diffractometer was irradiated with X rays to perform baseline correction. Thereafter, the peak intensity ratio of (002) plane to (100) plane of boron nitride was calculated. This peak intensity ratio was regarded as the orientation index [I(002)/I(100)]. Results were as shown in Table 1.

<Cross-section observation with electron microscope>

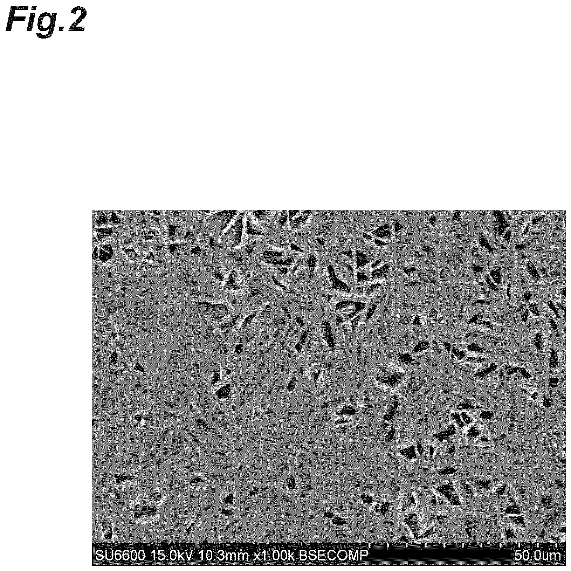

The boron nitride sintered body was cut along the thickness direction using a CP polishing machine to obtain a cross-section. This cross-section was observed with a scanning electron microscope (SEM). FIG. 2 is an SEM photograph (magnification: 1000) showing a cross-section of a boron nitride sintered body of Example 1.

(Example 2)

A fired product was prepared by the same procedures as in Example 1. Separately from this, powdery boric acid and calcium carbonate were blended to prepare a sintering aid. Upon the preparation, the blending ratio of boric acid and calcium carbonate was changed so that the atomic ratio of boron and calcium was set to 0.6 atom% of calcium with respect to 100 atom% of boron. 16 parts by mass of this sintering aid was blended with respect to 100 parts by mass of the fired product and mixed using a Henschel mixer to obtain a powdery blend. A sheet-shaped boron nitride sintered body (thickness: 5 mm) was manufactured in the same manner as in Example 1, except that this blend was used.

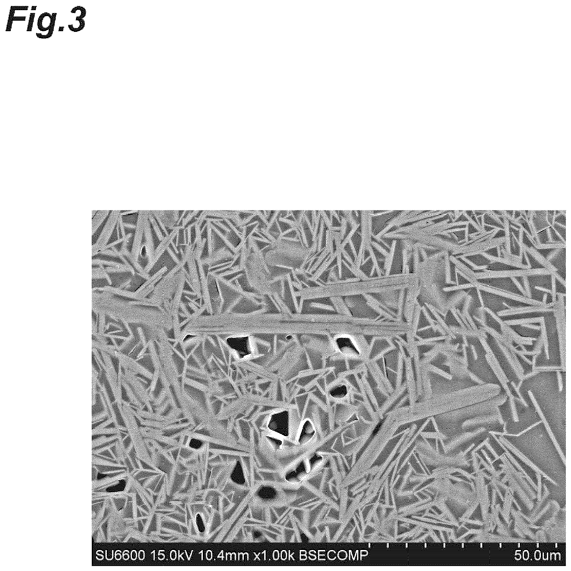

Each measurement and the cross-section observation with an electron microscope were performed in the same manner as in Example 1. Measurement results were as shown in Table 1. FIG. 3 is an SEM photograph (magnification: 1000) showing a cross-section of a boron nitride sintered body of Example 2.

(Comparative Example 1)

A fired product was prepared by the same procedures as in Example 1. Separately from this, powdery boric acid and calcium carbonate were blended to prepare a sintering aid. Upon the preparation, the blending ratio of boric acid and calcium carbonate was changed so that the atomic ratio of boron and calcium was set to 13.2 atom% of calcium with respect to 100 atom% of boron. 25 parts by mass of this sintering aid was blended with respect to 100 parts by mass of the fired product and mixed using a Henschel mixer to obtain a powdery blend. A sheet-shaped boron nitride sintered body (thickness: 5 mm) was manufactured in the same manner as in Example 1, except that this blend was used.

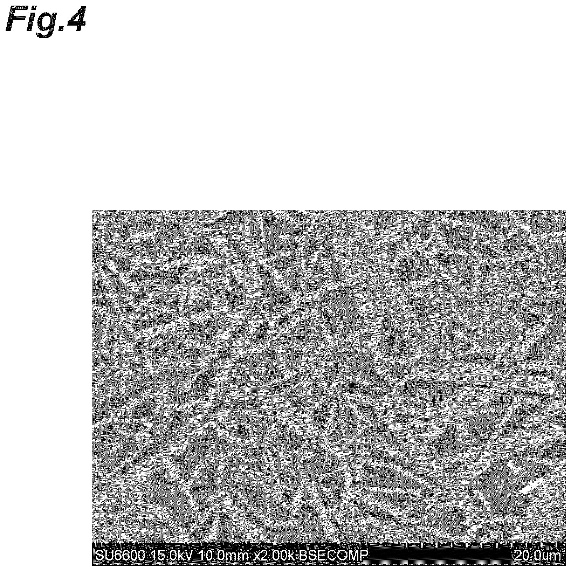

Each measurement and the cross-section observation with an electron microscope were performed in the same manner as in Example 1. Measurement results were as shown in Table 1. FIG. 4 is an SEM photograph (magnification: 2000) showing a cross-section of a boron nitride sintered body of Comparative Example 1.

(Comparative Example 2)

9 parts by mass of an amorphous boron nitride powder having an oxygen content of 2.0% and an average particle diameter of 3.4 μm, 13 parts by mass of a hexagonal boron nitride powder having an oxygen content of 0.3% and an average particle diameter of 12.5 μm, 0.1 parts by mass of calcium carbonate (manufactured by Shiraishi Kogyo Kaisha, Ltd., trade name: PC-700), and 0.2 parts by mass of boric acid were mixed using a Henschel mixer. Thereafter, 76.0 parts by mass of water was added and pulverized with a ball mill for 5 hours to obtain an aqueous slurry. Further, polyvinyl alcohol (manufactured by Nippon Synthetic Chemical Industry Co., Ltd., trade name: GOHSENOL) was added to be an amount of 0.5% by mass with respect to the aqueous slurry, heated and stirred at 50°C until dissolved, and then the aqueous slurry was subjected to a spheroidizing treatment at a drying temperature of 230°C in a spray dryer. As a spheroidizing device of the spray dryer, a rotary atomizer was used.

The granulated substance obtained by the spheroidizing treatment was filled in a boron nitride container and molded by being pressurized at 20 MPa by a cold isostatic pressing method (CIP). Subsequently, in the batch-type high-frequency furnace, heating was performed for 10 hours under the conditions of normal pressure, a nitrogen flow rate of 5 L/min, and 2050°C. Thereafter, a sheet-shaped boron nitride sintered body was extracted from the boron nitride container. The thickness of the boron nitride sintered body was 5 mm.

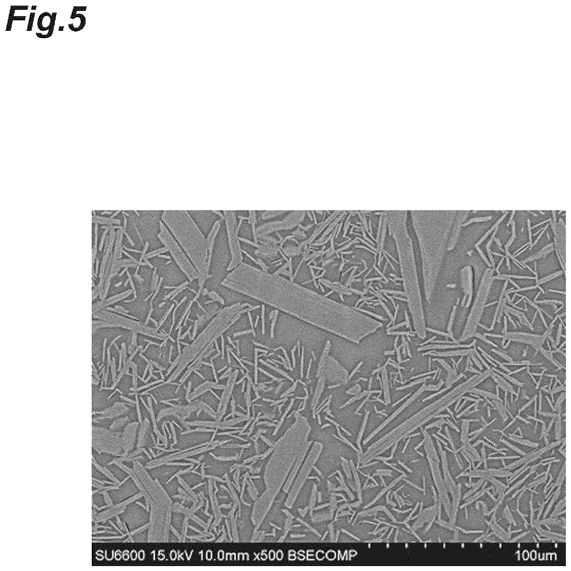

Each measurement and the cross-section observation with an electron microscope were performed in the same manner as in Example 1. Measurement results were as shown in Table 1. FIG. 5 is an SEM photograph (magnification: 500) showing a cross-section of a boron nitride sintered body of Comparative Example 2.

[Table 1]

| | Compressive elastic modulus [GPa] | Compressive strength [MPa] | Bulk density [kg/m³] | Thermal conductivity [W/(m·K)] | Porosity [% by volume] | Orientation index |
|---|---|---|---|---|---|---|
| Example 1 | 1.90 | 18.8 | 1330 | 57 | 42 | 7 |
| Example 2 | 1.24 | 13.1 | 1090 | 43 | 52 | 5 |
| Comparative Example 1 | 0.97 | 4.0 | 920 | 31 | 60 | 7 |
| Comparative Example 2 | 0.62 | 5.0 | 1060 | 36 | 54 | 7 |

[Composite body]

<Production of composite body>

A resin composition containing an epoxy resin (manufactured by Mitsubishi Chemical Corporation, trade name: Epikote 807) and a curing agent (manufactured by Nippon Synthetic Chemical Industry Co., Ltd., trade name: Akumex H-84B) was applied to each of the boron nitride sintered bodies of Examples 1 and 2 using a bar coater at the atmospheric pressure, and each boron nitride sintered body was impregnated with the resin composition. After the impregnating, the resin was cured by heating at the atmospheric pressure and at a temperature of 120°C for 120 minutes to obtain composite bodies. These composite bodies had the thickness and the thermal conductivity that were equal to those of the boron nitride sintered body. Therefore, the composite body is useful as a heat dissipation member of an electronic component.

The content of the resin in each composite body was as shown in Table 2. The content (% by mass) of this resin is a mass ratio of the resin to the entire composite body. The content of the resin was calculated by calculating the mass of the resin from a difference in mass of the boron nitride sintered body and the composite body and dividing this mass of the resin by the mass of the composite body.

[Table 2]

|  | Content ratio of resin [% by mass] |
|---|---|
| Example 1 | 28 |
| Example 2 | 38 |
| Comparative Example 1 | 46 |
| Comparative Example 2 | 39 |

**Industrial Applicability**

According to the present disclosure, there are provided a boron nitride sintered body and a composite body which are thin and suitable as a member of an electronic component and the like, and manufacturing methods therefor. Furthermore, a heat dissipation member which is suitable as a member of an electronic component and the like is provided.

**Reference Signs List**

10: boron nitride sintered body.

**Claims**

1.   A boron nitride sintered body comprising:

       boron nitride particles and pores,
       wherein a compressive elastic modulus is 1 GPa or more.

2.   The boron nitride sintered body according to claim 1, wherein a compressive strength is 3 MPa or more.

3.   The boron nitride sintered body according to claim 1 or 2, wherein a porosity is 30 to 65% by volume.

4.   The boron nitride sintered body according to any one of claims 1 to 3, wherein a bulk density is 900 to 1500 kg/m$^3$.

5.   The boron nitride sintered body according to any one of claims 1 to 4, wherein an orientation index is 20 or less.

6.   The boron nitride sintered body according to any one of claims 1 to 5, wherein the boron nitride sintered body has a sheet shape and a thickness of less than 5 mm.

7.   A composite body comprising: the boron nitride sintered body according to any one of claims 1 to 6; and a resin filled in at least some of the pores of the boron nitride sintered body.

8.   A heat dissipation member comprising the composite body according to claim 7.

9.   A method for manufacturing a boron nitride sintered body, the method comprising:

       a nitriding step of firing a boron carbide powder in a nitrogen atmosphere to obtain a fired product containing boron carbonitride; and
       a sintering step of molding and heating a blend containing the fired product and a sintering aid to obtain the boron nitride sintered body including boron nitride particles and pores, wherein
       the sintering aid contains a boron compound and a calcium compound, and
       the blend contains 1 to 20 parts by mass of the boron compound and the calcium compound in total with respect to 100 parts by mass of the fired product.

10.   The method for manufacturing the boron nitride sintered body according to claim 9, wherein a compressive elastic modulus of the boron nitride sintered body obtained in the sintering step is 1 GPa or more.

11.   The method for manufacturing the boron nitride sintered body according to claim 9 or 10, wherein the blend contains 0.5 to 40 atom% of calcium constituting the calcium compound with respect to 100 atom% of boron constituting the boron compound.

12. The method for manufacturing the boron nitride sintered body according to any one of claims 9 to 11, wherein the boron nitride sintered body obtained in the sintering step has a sheet shape and a thickness of less than 2 mm.

13. A method for manufacturing a composite body, the method comprising:

an impregnating step of impregnating a boron nitride sintered body obtained by the manufacturing method according to any one of claims 9 to 12 with a resin composition,
the composite body having the boron nitride sintered body and a resin filled in at least some of the pores of the boron nitride sintered body.

*Fig.1*

10

10a

t

**Fig.2**

SU6600 15.0kV 10.3mm x1.00k BSECOMP                    50.0um

# Fig.3

SU6600 15.0kV 10.4mm x1.00k BSECOMP      50.0um

# Fig.4

SU6600 15.0kV 10.0mm x2.00k BSECOMP      20.0um

# Fig.5

SU6600 15.0kV 10.0mm x500 BSECOMP                    100um

**INTERNATIONAL SEARCH REPORT**

| International application No. |
| --- |
| PCT/JP2021/013576 |

A. CLASSIFICATION OF SUBJECT MATTER
H01L 23/373(2006.01)i; C04B 38/00(2006.01)i; C04B 41/83(2006.01)i; C04B 35/583(2006.01)i; H05K 7/20(2006.01)i
FI: C04B35/583; C04B38/00 303Z; C04B41/83 G; H01L23/36 M; H05K7/20 F
According to International Patent Classification (IPC) or to both national classification and IPC

B. FIELDS SEARCHED

Minimum documentation searched (classification system followed by classification symbols)
H01L23/373; C04B38/00; C04B41/83; C04B35/583; H05K7/20

Documentation searched other than minimum documentation to the extent that such documents are included in the fields searched
Published examined utility model applications of Japan          1922–1996
Published unexamined utility model applications of Japan      1971–2021
Registered utility model specifications of Japan                   1996–2021
Published registered utility model applications of Japan        1994–2021

Electronic data base consulted during the international search (name of data base and, where practicable, search terms used)
JSTPlus/JST7580/JSTChina (JDreamIII)

C. DOCUMENTS CONSIDERED TO BE RELEVANT

| Category* | Citation of document, with indication, where appropriate, of the relevant passages | Relevant to claim No. |
| --- | --- | --- |
| X<br>A | JP 7-61855 A (SHINAGAWA REFRACT CO., LTD.) 07 March 1995 (1995-03-07) claims, table 1<br>claims, table 1 | 1–6<br>7–13 |
| A | WO 2017/155110 A1 (DENKA COMPANY LIMITED) 14 September 2017 (2017-09-14) entire text | 1–13 |
| A | JP 2016-103611 A (DENKA COMPANY LIMITED) 02 June 2016 (2016-06-02) entire text | 1–13 |

☐ Further documents are listed in the continuation of Box C.          ☒ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>04 June 2021 (04.06.2021) | Date of mailing of the international search report<br>15 June 2021 (15.06.2021) |
| --- | --- |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

INTERNATIONAL SEARCH REPORT

Information on patent family members

| International application No. |
| --- |
| PCT/JP2021/013576 |

| Patent Documents referred in the Report | Publication Date | Patent Family | Publication Date |
| --- | --- | --- | --- |
| JP 7-61855 A | 07 Mar. 1995 | (Family: none) | |
| WO 2017/155110 A1 | 14 Sep. 2017 | US 2019/0092695 A1 entire text EP 3428223 A1 KR 10-2018-0124915 A CN 109153801 A | |
| JP 2016-103611 A | 02 Jun. 2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014162697 A